# EUROPEAN PATENT SPECIFICATION

(11) **EP 1 602 936 B1**
(45) Date of publication and mention of the grant of the patent: **06.06.2012**
(21) Application number: 05076754.0
(22) Date of filing: 24.02.2004
(51) Int. Cl.: G01R 33/028, H01L 43/00, G01R 33/02, G01R 33/04

(54) **Magnetic field detecting element and method for manufacturing the same**
Verfahren zur Herstellung eines Magnetfelddetektors
Procédé de fabrication d'un dispositif de détection de champs magnétiques

(30) Priority: 25.02.2003 KR 2003011807; 28.05.2003 KR 2003034191
(43) Date of publication of application: 07.12.2005
(62) Divisional of application: 04251015.6
(73) Proprietor: Samsung Electronics Co., Ltd, Suwon-si, Gyeonggi-do (KR)
(72) Inventor: Shim, Dong-sik, Seoul (KR); Na, Kyung-won, Seoul (KR); Choi, Sang-on, 436-603 Samsung Apartment, Suwon-si Gyeonggi-do (KR); Park, Hae-seok, Seoul (KR); Hwang, Jun-sik, Yongin-si Gyeonggi-do (KR)
(74) Representative: Ertl, Nicholas Justin

(56) References cited:
- EP-A- 1 345 038
- EP-A- 1 441 234
- EP-A- 1 447 674
- DE-A- 4 220 186
- DE-A1- 3 420 709
- US-B1- 6 411 086
- US-B1- 6 414 564
- US-B1- 6 429 651

## Description

The present invention relates to a method for manufacturing a magnetic field detecting device by forming a soft magnetic core and a coil in a thin film type on a semiconductor substrate using a semiconductor process.

A magnetic sensor using a soft magnetic material and a coil has been used as a magnetic sensor of high sensitivity for a long time. Such magnetic sensor is usually manufactured by a coil wound on a soft magnetic core, and requires an electronic circuit for obtaining magnetic field proportional to measured magnetic field. Recently, a method for realizing such magnetic filed detecting element of the magnetic sensor in form of the soft magnetic thin film core and a plane thin film coil on the semiconductor substrate using the semiconductor process, has been suggested.

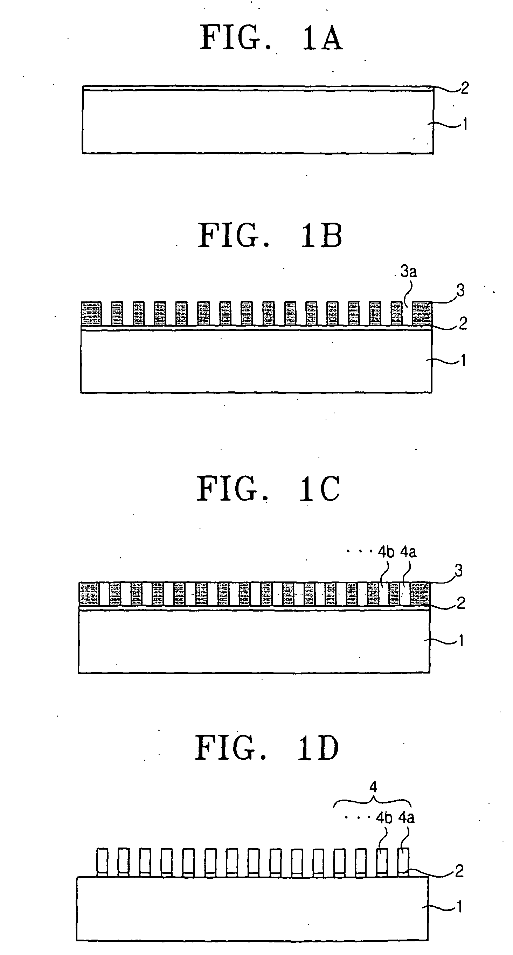

A general method for manufacturing a magnetic field detecting element using the semiconductor process will be briefly described with reference to FIG. 1A through FIG 1J in the following.

Initially, as shown in FIG. 1A, the first seed film 2 is formed on a semiconductor substrate 1. After a photoresist of a predetermined height is spread on the first seed film 2, the first plating mold 3 having a plurality of grooves 3a is formed by exposing and developing processes as shown in FIG 1B. After that, metal is filled up in the groove 3a of the first plating mold 3 through the process such as an electric plating so that a plurality of coil lines 4a, 4b,... may be formed as shown in FIG 1C. After that, the first plating mold 3 and the seed film under the plating mold 3 are removed so that the first coil 4 consisting of a plurality of coil lines 4a, 4b,...that are insulated each other may be formed as shown in FIG. 1D.

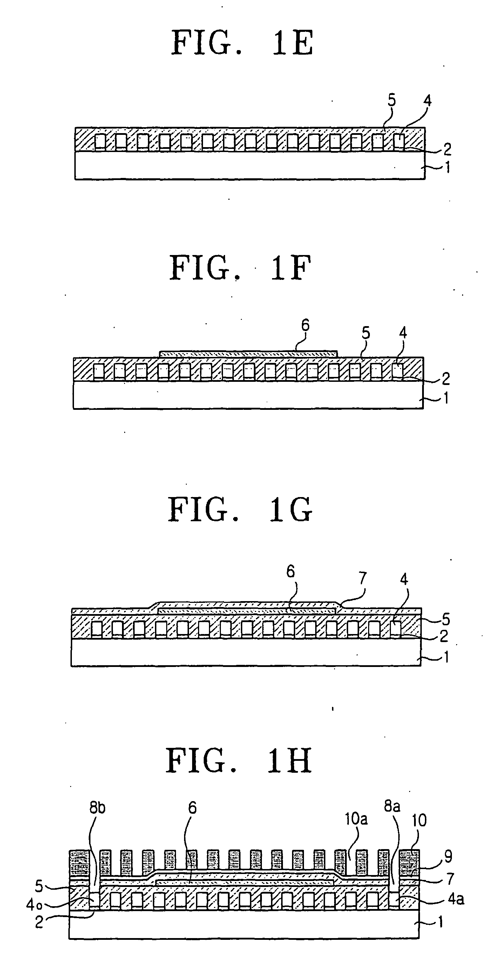

After the first coil 4 is formed, the first insulating film 5 is formed at the height higher than the height of the first coil 4 on the semiconductor substrate 1 as shown in FIG 1E. After that, a soft magnetic material film is spread on the upper part of the first insulating film 5 and a soft magnetic core 6 is formed by a pattern formation and etching (refer to FIG 1F).

Subsequently, a second insulating film 7 of a predetermined thickness is formed on the soft magnetic core 6 of the semiconductor substrate 1 as shown in FIG 1G, and as shown in FIG. 1H, via holes 8a, 8b for communicating with the coil lines 4a, 4o forming both ends of the first coil 4, are formed, and a second seed film 9 is formed in a predetermined thickness on the upper part of the second insulating film 7, then a photoresist is spread thick on the second seed film 9 and the second plating mold 10 having a plurality of grooves 10a is formed by exposing and developing processes.

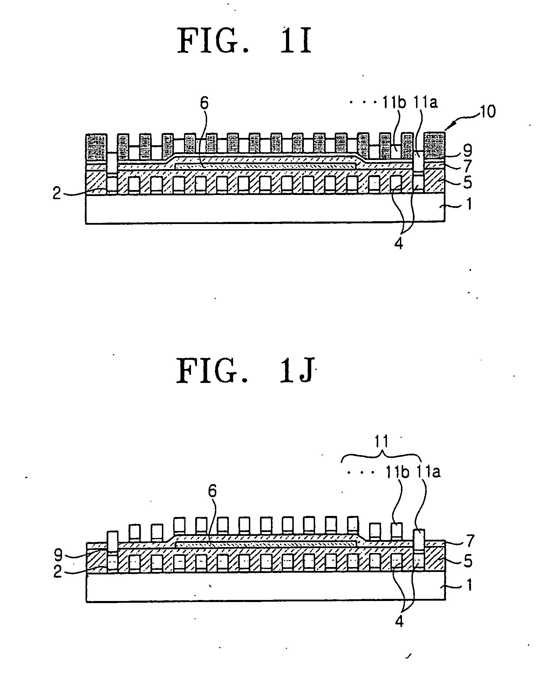

After that, as shown in FIG 1I, metal is filled up in the groove 10a of the second plating mold 10 so that a plurality of coil lines 11a, 11b,...may be formed. Then, the second plating mold 10 and the second seed film 9 under the second plating mold 10 are removed so that the second coil 11 consisting of a plurality of coil lines 11a, 11b,...that are insulated each other may be formed as shown in FIG 1J.

Lastly, though not shown in the drawing, a protection film is spread on the upper part of the second coil 11, whereby manufacturing of the magnetic field detecting element is completed.

However, according to the foregoing general method for manufacturing the magnetic field detecting element, the seed film 2 between the coil lines 4a, 4b,...should be removed in order for each coil line 4a, 4b,...constituting the first coil 4 to be insulated from each other. For that purpose, after the first plating mold 3 is removed, the process of spreading the insulating film 5 again is added for the subsequent process, whereby the manufacturing process is complicated.

In the meantime, the performance of the soft magnetic core 6 in the foregoing magnetic field detecting element, is not very good in case that the semiconductor substrate 1 for supporting the core is not even. Since having a structure in which the first coil 4 projects from the semiconductor substrate 1, the general magnetic field detecting element has weak point that the thickness of the first and the second insulating films 5, 7 for insulation and planarization, becomes thick. If the thickness of the insulating films 5, 7 becomes thick, not only the whole thickness of the element becomes thick but also the process for forming the via holes 8a, 8b for connecting the first coil 4 with the second coil 11 becomes difficult. Also, a pitch between the coil lines that has an influence on the performance of the sensor gets large, which shows a negative effect.

Fluxgate sensors integrated in semiconductor substrate and methods for manufacturing the same are presented in European Patent Application Publication numbers EP1345038 and EP 1441234.

The fluxgate sensor of EP1345038 includes: a soft magnetic core formed to form a closed magnetic path on a semiconductor substrate; an excitation coil formed as a metal film, winding the soft magnetic core; and a pick-up coil formed on the same plane as the excitation coil, the pick-up coil formed as a metal film for winding the soft magnetic core.

The fluxgate sensor of EP1441234 comprises a soft magnetic core formed on a semiconductor substrate; an excitation coil winding the soft magnetic core and being insulated by an insulating layer deposited at upper and lower sides of the soft magnetic core; and a pick-up coil, winding the soft magnetic core and being insulated by an insulating layer deposited at upper and lower sides of the excitation coil.

European Patent Application Publication Number EP1447674 discloses a magnetic field sensing device and a method for fabricating the same. The magnetic field sensor includes a soft magnetic core formed to create a closed-magnetic circuit on a semiconductor substrate, a magnetic field sensing coil formed by a metal film in a shape that winds the soft magnetic core, and a drive line (50) for exciting the soft magnetic core.

A differential solenoidal magnetic field sensing device is proposed by Chois S et al in United States Patent number US 6,411,086. The differential solenoidal magnetic field sensing device includes a semiconducor substrate, soft magnetic film cores stacked on the substrate to form closed magnetic paths parallel to each other, a solenoidal excitation coil formed of a metal thin film, and a solenoidal magnetic flux variation detecting coil.

United States Patent number US 6,429,651 discloses a differential spiral magnetic field sensing device. The differential spiral magnetic field sensing device includes a semiconductor substrate, soft magnetic film cores stacked on the substrate to form closed magnetic paths, an excitation coil formed of a metal thin film, a magnetic flux variation detecting coil made of a metal thin film, and a zero magnetic field detecting coil for generating anti-magnetic field components.

According to the invention, there is provided a method for manufacturing a magnetic field detecting element according to claim 1.

Also, the step of forming the first coil may further comprise the steps of: forming a first seed film on a surface of the well; forming a first plating mold having a plurality of grooves on the first seed film; forming a plurality of coil lines constituting the first coil by filling up metal in each groove of the first plating mold; and removing the first plating mold and the first seed film under the first plating mold.

Also, the step of forming the second coil may further comprise the steps of: forming a via hole by etching the first and the second insulating films on both sides of the soft magnetic core; forming a second seed film on an upper surface of the second insulating film on which the via hole is formed; forming a second plating mold having a plurality of grooves, on the second seed film; forming a plurality of coil lines constituting a second coil by filling up metal in each groove of the second plating mold, and connecting the first coil with the second coil through the via hole; and removing the second plating mold and the second seed film under the second plating mold.

The method may further comprise the step of forming a protection film for protecting structures including the second coil.

According to the invention, there is also provided a magnetic field detecting element according to claim 8.

Examples of the invention will now be described in detail with reference to the accompanying drawings, in which:
FIG 1A through FIG 1J are cross-sectional views for explaining the general method for manufacturing a magnetic field detecting element;
FIG 2A through FIG 2K are cross-sectional views for explaining a method for manufacturing a magnetic field detecting element and which explains some principles which can be applied to the method of invention;
FIG 3A is a plan view showing a status that a seed film formed on the semiconductor substrate is removed by a predetermined pattern;
FIG 3B is a plan view showing a cut-off line for cutting off the semiconductor substrate in order to insulate coil lines after forming a plurality of coil lines on the seed film shown in FIG. 3A;
FIG 4 is a cross-sectional view for explaining a modified example of a method for manufacturing a magnetic field detecting element;
FIG 5A through FIG 5I are cross-sectional views for explaining another method for manufacturing a magnetic field detecting element;
FIG. 6A through FIG 6H are cross-sectional views for explaining a method for manufacturing a magnetic field detecting element according to the present invention; and
FIG 7A through FIG 7H are cross-sectional views taken along line III-III of FIG. 6A through FIG. 6H, respectively.

A preferred embodiment of the present invention will now be described with reference to the accompanying drawings.

The detailed examples given are chosen to assist in a comprehensive understanding of the invention. Thus, it is apparent that the present invention can be carried out in other different ways. Also, well-known functions or constructions are not described in detail since they would obscure the invention in unnecessary detail.

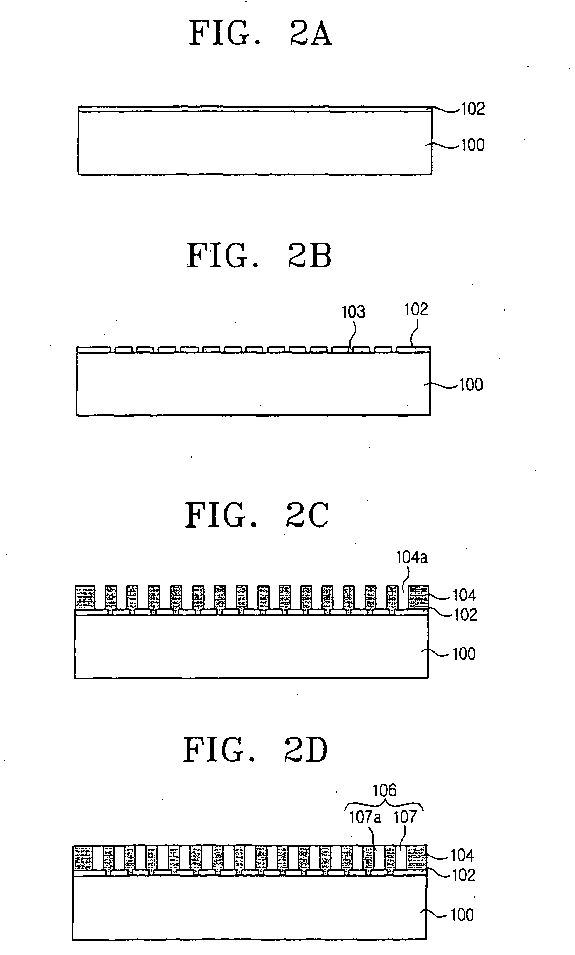

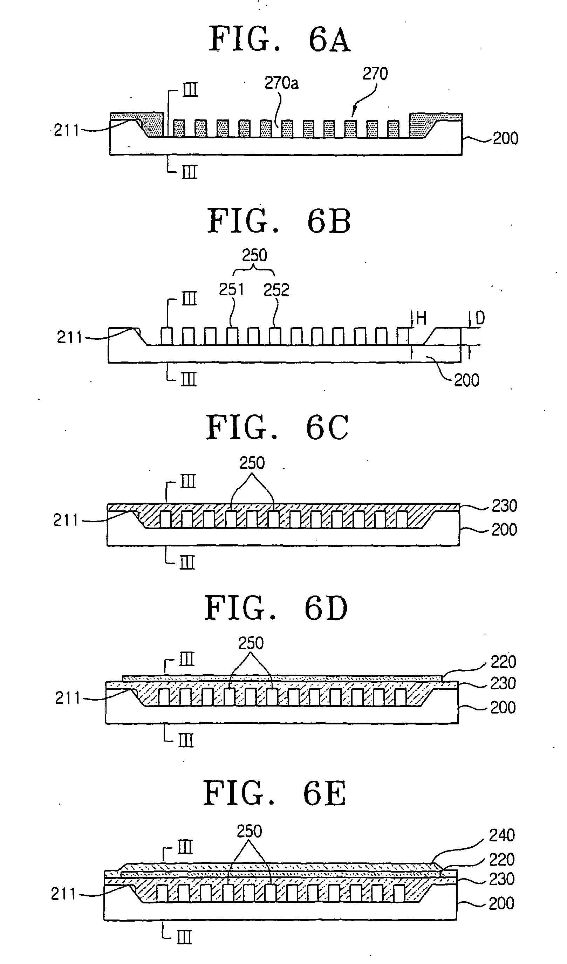

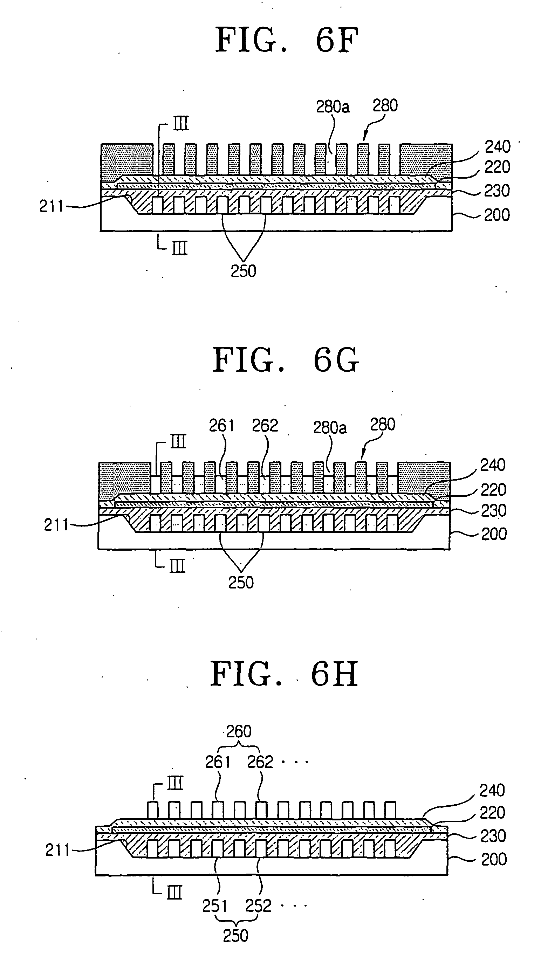

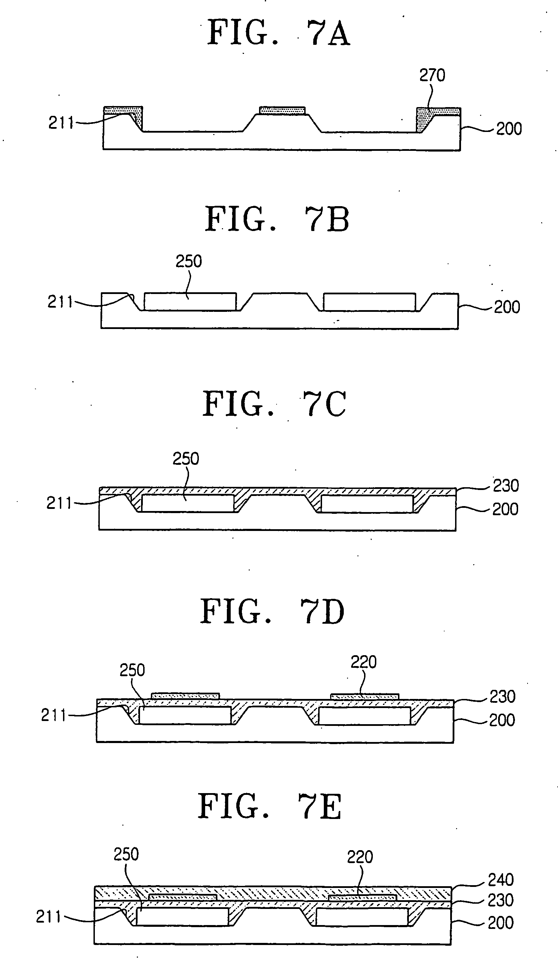

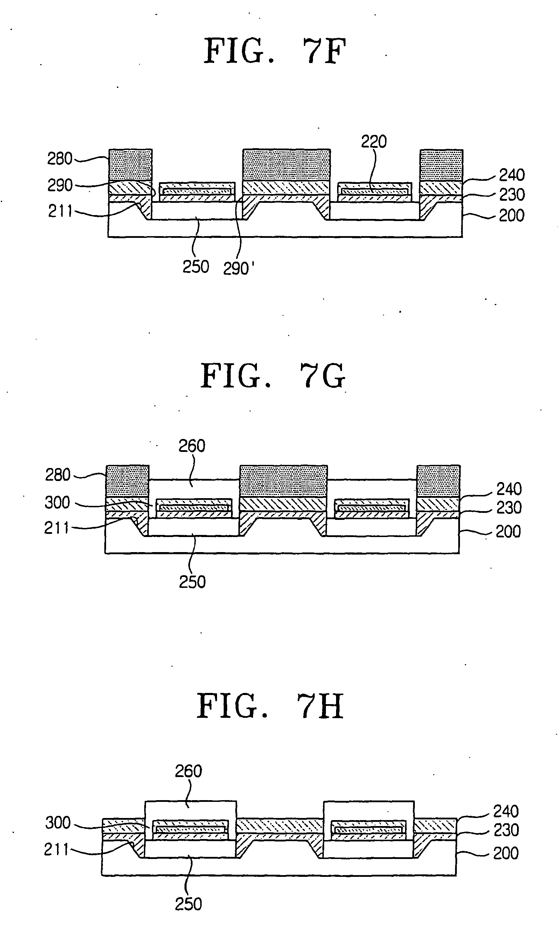

FIG 2A through FIG 2K are views showing process of a method for manufacturing a magnetic field detecting element and which illustrates some principles which can be used in the method of the invention (which is shown in Figures 6 and 7). Referring to these drawings, the first step in this method for manufacturing a magnetic field detecting element is to form an oxidation film (not shown) for electric insulation, on a semiconductor substrate 100, and to form the first seed layer 102 for plating, on that oxidation film as shown in FIG 2A.

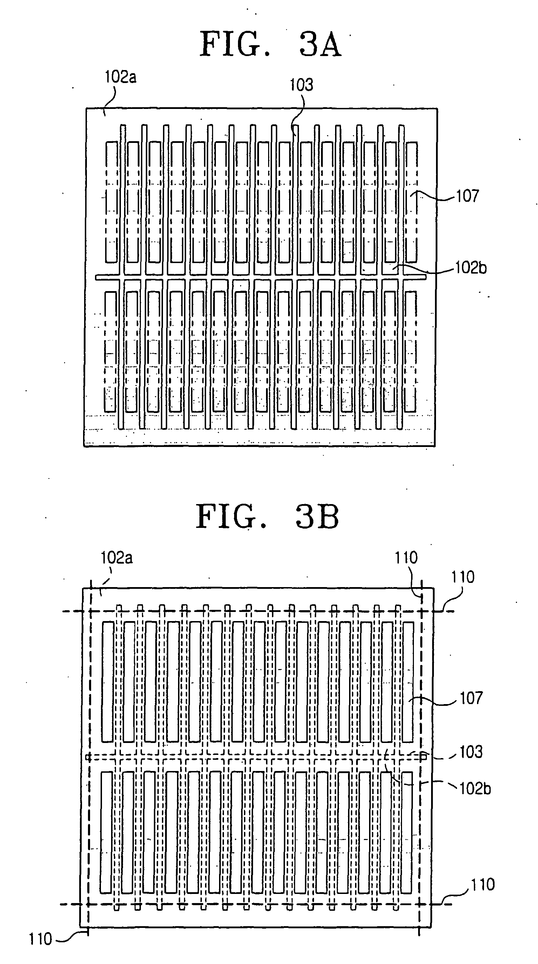

After that, as shown in FIG 2B, the first seed film 102 spread on the semiconductor substrate 100 is partially removed with use of a predetermined pattern, i.e., the pattern as shown in FIG. 3A. The removal of the first seed film 102 is for insulating, in a simple manner, a plurality of coil lines constituting the first coil that would be formed on the first seed film 102 as will be described below. Here, the reference numerals 103 and 107 in FIG. 3A are a seed film pattern to be removed and a position of a plurality of the coil lines. As shown in the drawing, the pattern 103 is positioned between a plurality of the coil lines, whereby a plurality of the coil lines is partitioned from the neighboring coil lines and connected through the seed film at the edges. As a result, as shown in FIG 3B, if four lines 110 connecting the edges of the pattern 103 are cut, the positions of the coil lines are insulated each other.

The removal of such first seed film 102 is performed in the following way, in which the seed film pattern 103 that would be removed by exposing and developing processes is formed after the photoresist is spread on the first seed film 102. At this time, the seed film pattern 103 that would be removed is formed in such a way that parts 102b where a plurality of coil lines 107 constituting the first coil 106 are to be formed, are insulated from each other and edges 102a are connected each other as shown in FIG 3A.

The seed film 102 is electrically connected from the viewpoint of the whole semiconductor substrate 100, but the parts 102b where a plurality of the coil lines 107 constituting the first coil 106 would be formed, is formed in such a way that the parts 102b could be electrically insulated each other if the connection parts, i.e., the edges 102a are cut. Here, generally, the first coil is formed in such a way that an exciting coil and an magnetic field detecting coil are wired one time by turns. Also, only one of either the exciting coil or the magnetic field detecting coil may be wired in form of a solenoid. After that, the pattern 103 of the seed film 102 is removed through etching, then the photoresist is removed, whereby partial removal of the seed film is completed.

Then, after the photoresist is spread thick on the upper surface of the first seed film 102 that has been partially removed with use of a predetermined pattern 103, the first plating mold 104 having a plurality of grooves 104a is formed by exposing and developing processes (refer to FIG. 2C), and metal is filled in the groove 104a of the first mold 104, so that a plurality of coil lines 107, 107a constituting the first coil 106, is formed. At this time, by electric plating, metal sticks to and grows on the seed film in the lower part of the groove 104a of the first plating mold 104, whereby a plurality of coil lines 107, 107a is formed as shown in FIG. 2D.

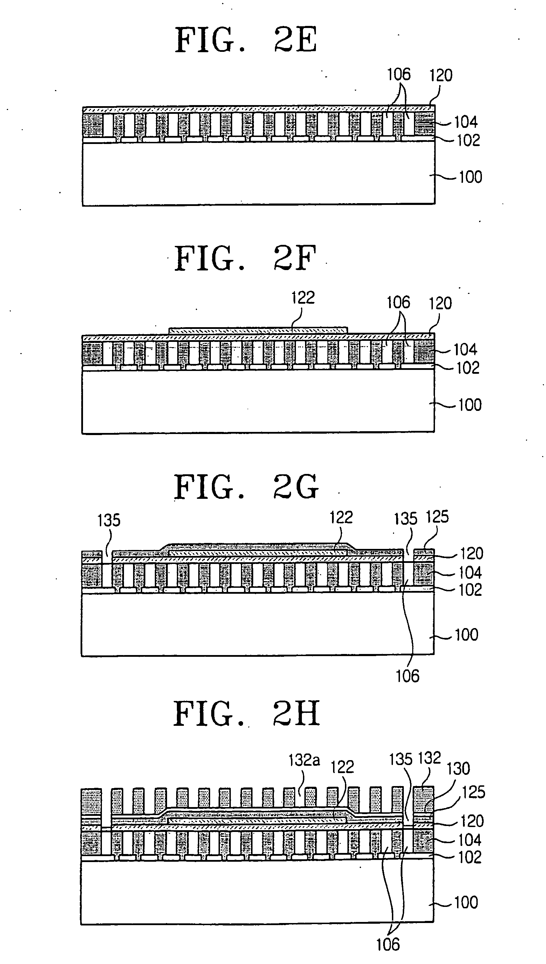

After that, with an upper surface of the first plating mold 104 processed evenly, a first insulating film 120 is formed in a predetermined thickness on that evenly processed upper surface as shown in FIG. 2E. Then, a soft magnetic material film is stacked on the upper part of the first insulating film 120 and a soft magnetic core 122 is formed by pattern formation and etching (refer to FIG. 2F).

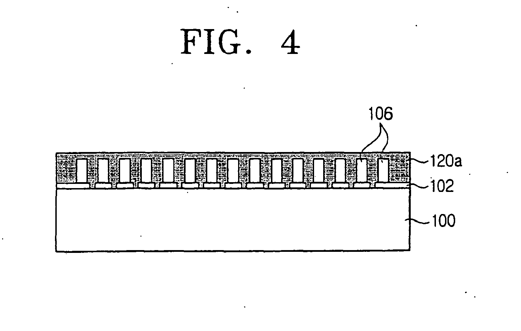

In the meantime, the insulating film for forming the soft magnetic core 122 may be formed in such a way that the first plating mold 104 is removed and the insulating material is spread in a height higher than a height of the first coil 106, on the semiconductor substrate 100 so that a first insulating film 120A is formed as shown in FIG 4. According to such method, there is a strong point that planarization process needs not to be performed.

After the soft magnetic core 122 is formed in a foregoing manner, a second insulating film 125 is formed in a predetermined thickness, on the first insulating film 120 of the semiconductor substrate 100 as shown in FIG. 2G Then, a via hole 135 for communicating with the coil lines that form both ends of the first coil 106, is formed at the second insulating film 125.

After that, as shown in FIG 2H, a second seed film 130 is formed on the upper surface of the second insulating film 125 and a photoresist is spread thick on the second seed film 130, then a second plating mold 132 having a pattern that corresponds to a shape of a second coil 136, i.e., a plurality of grooves 132a, is formed by exposing and developing processes. At this time, the second coil 136 which corresponds to the first coil 106, may be formed in such a way that an exciting coil and an magnetic field detecting coil are wired one time by turns, or only one of either the exciting coil or the magnetic field detecting coil may be wired in form of a solenoid.

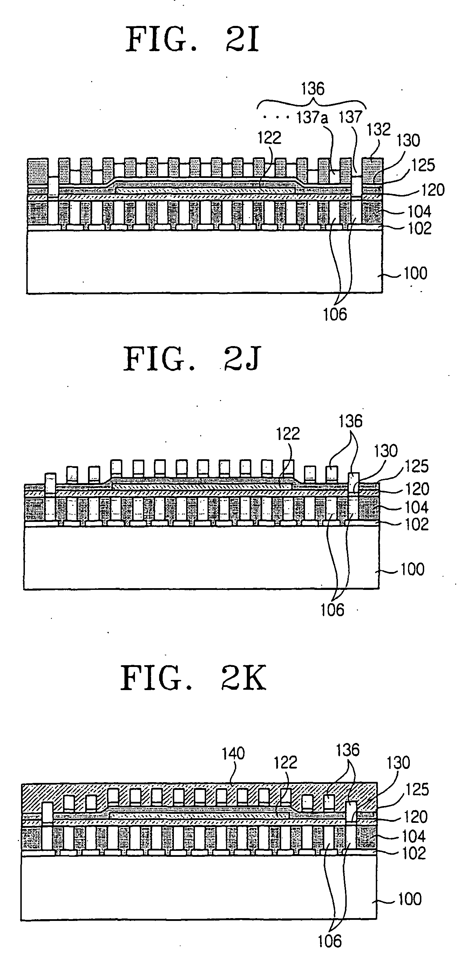

After that, metal is filled in the groove 132a of the second plating mold 132 by electric plating so that a plurality of coil lines 137, 137a constituting the second coil 136 is formed (refer to FIG 2I). Then, if the second plating mold 132 and the seed film under that second plating mold" 132 are removed, a magnetic field detecting element having the second coil 136 is obtained as shown in FIG 2J.

FIG. 2K shows that a protection film 140 for protecting structures including the second coil 136 is formed on the upper part of the second coil 136.

As described, after the first coil 106, the soft magnetic core 122, and the second coil 136 are formed on the semiconductor substrate 100, a portion 102a that corresponds to the edges of the first seed film 102 is cut off along a cut-off line 110 by dicing process as shown in FIG 3B. Thus, as shown in the drawing, a plurality of the coil lines 107 constituting the first coil 106 is electrically separated and insulated each other.

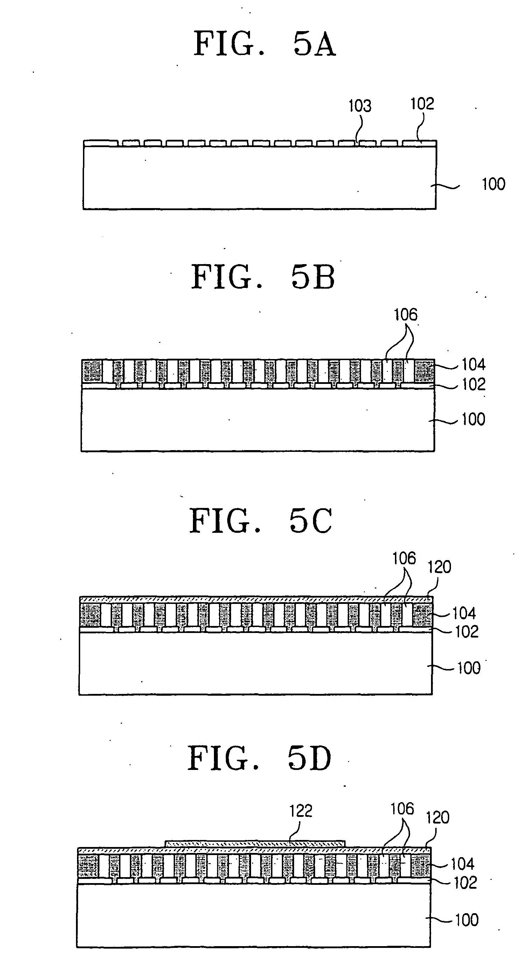

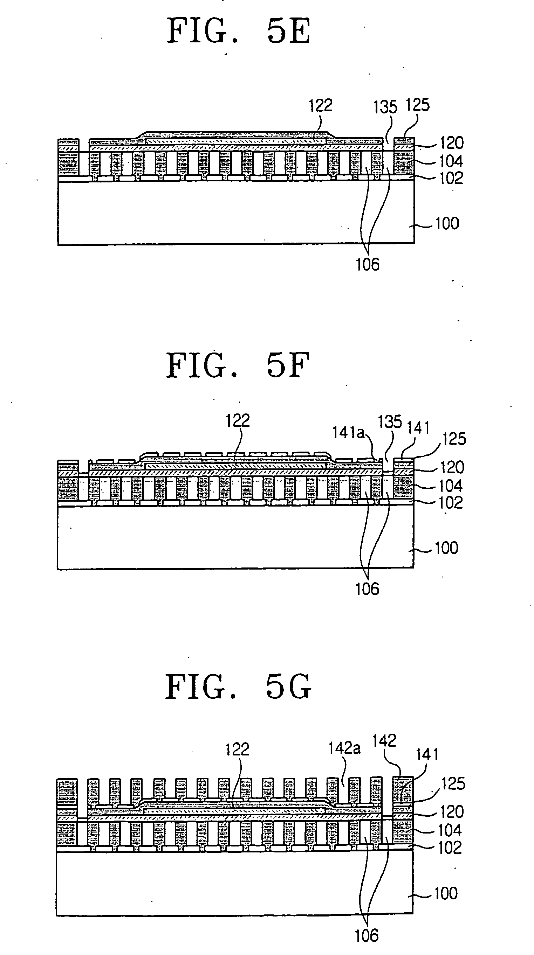

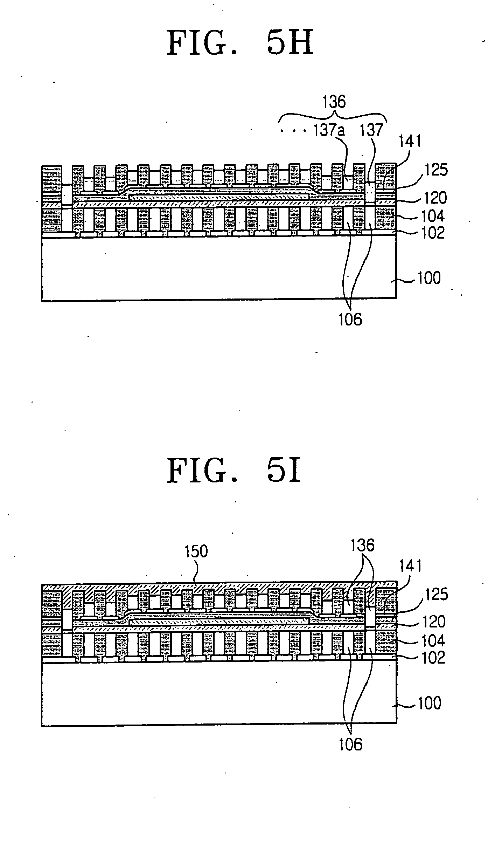

FIG 5A through FIG 5I are cross-sectional views for explaining another method for manufacturing a magnetic field detecting element. The magnetic field detecting element is characterized in applying the structure and process in forming the second coil 136 as well as the above-described first coil 106, which will be described in the following.

Since the processes up to the process for forming the second insulating film 125 after forming the oxidation film on the semiconductor substrate 100, are the same as the process of the foregoing embodiment (refer to FIG 5A through FIG 5E), detailed description thereof will be omitted.

Next, as shown in FIG 5F, a second seed film 141 is formed on the upper surface of the second insulating film 125, and that second seed film 141 is partially removed by the same method and pattern as those of the first seed film 102. Namely, after the photoresist is spread on the second seed film 141, a seed film pattern 141a to be removed is formed by exposing and developing processes. At this time, the seed film pattern 141a to be removed, is formed in such a way that a plurality of the coil lines 137 constituting the second coil 136 are insulated from each other in their sides and a plurality of the coil lines 137 is connected by means of the edges of the seed film 141. Namely, the seed film pattern 141a is formed in the same manner as the pattern 103 of the above-described first seed film 102.

Therefore, if the semiconductor substrate 100 is cut off along its edges, the coil lines 137 are electrically separated and insulated. At this time, it is preferable that the cut-off line (not shown) of the second coil 136 is overlapped on the cut-off line 110 of the first coil 106 so that a plurality of the coil lines 107, 137 constituting the first and the second coils 106, 136, respectively, is separated and insulated simultaneously by one time of dicing process.

After that, the photoresist is spread thick on the upper surface of the second seed film 141 that has been partially removed by a predetermined pattern, then a second plating mold 142 having a pattern that corresponds to the second coil 136, i.e., a plurality of the grooves 142a, is formed by exposing and developing processes (refer to FIG. 5G). After that, as shown in FIG 5H, metal is filled in the groove 142a of the second plating mold 142 so that a plurality of the coil lines 137, 137a is formed.

Then, a protection film 150 is spread on the upper part of the structures including the second plating mold 142, and finally the semiconductor 100 is cut off according to a cut-off line 110 by the dicing process (refer to FIG 3B).

Since the plating mold needs not to be removed for removal of the seed film as described above according to the method for manufacturing the magnetic field detecting element of the present invention, it is possible to provide the magnetic field detecting element such that the manufacturing process is simple and there are small restrictions in materials used for the insulating film.

The accompanying FIG. 6A through FIG. 6H are drawings for explaining a method for manufacturing a magnetic field detecting element according to the present invention, and FIG 7A through FIG. 7H are cross-sectional views taken along lines III-III of FIG 6A through FIG. 6H, respectively.

Referring to FIG. 6H and FIG. 7H, the magnetic field detecting element manufactured according to the manufacturing method of the present invention, comprises: a semiconductor substrate 200; a soft magnetic core 220; the first and the second insulating films 230, 240 positioned at the upper and the lower parts of the soft magnetic core 220; and the first and the second coils 250, 260 formed in such a way that those coils enclose the soft magnetic core 220 with the soft magnetic core 220 and the insulating films 230, 240 intervened, and having a plurality of coil lines 251, 252,..., 261, 262,..., respectively.

The first coil 250 is positioned on the lower side of the soft magnetic core 220, and the second coil 260 is positioned on the upper side of the soft magnetic core 220. Particularly, the semiconductor substrate 200 has an approximately rectangular well 211 that collapses in a predetermined depth D from its surface and the first coil 250 is arranged in the inside of that well 211 so that the first coil 250 may not be exposed to the surface of the semiconductor substrate 200 according to the characteristics of the present invention.

The height H of a plurality of the coil lines 51 constituting the first coil 250 formed in the inside of the well 211 is the same as the depth of the well 211. Therefore, the upper surface of the coil lines 251 maintains the same plane as the upper surface of the semiconductor substrate 200.

As described above, unlike the conventional art, since the first coil 250 is not projected to the surface of the semiconductor substrate 200 but is formed in the same plane as the upper surface of the semiconductor substrate 200 in the inside of the well 211 of the semiconductor substrate 200, it is easy to perform planarization of the semiconductor substrate 200 in which the first coil 250 is formed and it is possible to make very thin the thickness of a planarization material, for example, the insulating films 230, 240.

Therefore, performance deterioration of the soft magnetic core 220 generated due to unevenness of the conventional semiconductor substrate and difficulty in etching process generated due to the characteristics that the thickness of the insulating film is thick, are resolved and the magnetic field detecting element of high sensitivity, wherein the pitch between the coils is fine, is possibly manufactured.

In the meantime, the approximately rectangular well 211 is formed in such a way that the well has an inclined sidewall that is gradually inclined in its inside from its upper part to its bottom and may be formed by a variety of the etching technologies generally well known.

Also, as shown in FIG 7F and FIG 7G, the first and the second coils 250, 260 are connected, by means of a third coil 300 filled upon formation of the second coil 260, to through holes 290, 290' formed on both ends of the soft magnetic core 220 by passing through the first and the second insulating films 230, 240.

The method for manufacturing the magnetic field detecting element according to the present invention will be described in the following.

FIG 6A and FIG 7A are cross-sectional views showing that a first plating mold 270 for forming the first coil 250 is formed on the upper surface of the semiconductor substrate 200 in which the well 211 is formed. Although specifically not shown in the drawing, a seed film for plating is formed on the surface of the well 211, and the first plating mold 270 is formed by exposing and developing processes after the photoresist is spread thick on the seed film. In the drawing, the reference numeral 270a is a groove of the first plating mold 270.

If the seed film and the first plating mold are removed after metal is filled in such groove 270a of the first plating mold 270 by means of the electric plating method so that the coil line 251 1 is formed, the first coil 250 as shown in FIG 6B and FIG. 7B is formed on the well 211 of the semiconductor substrate 200. The first coil 250 does not project beyond the surface of the semiconductor substrate 200 but formed in the same plane as the semiconductor substrate 200.

After that, as shown in FIG. 6C and FIG 7C, an insulating material is spread on the upper surface of the semiconductor substrate 200 in which the first coil 250 is formed, so that a first insulating film 230 for planarization and insulation, is formed. Since the first coil 250 does not project beyond the surface of the semiconductor substrate 200 but maintains the same plane as the semiconductor substrate, it is easy to perform planarization and it is possible to make the insulating film 230 very thin as well.

After the first insulating film 230 is formed, a soft magnetic material film is stacked on the first insulating film 230 and a soft magnetic core 220 is formed by pattern formation and etching as shown in FIG. 6D and FIG 7D.

After that, an insulating material is spread in a predetermined thickness, on the upper part of the first insulating film 230 including the soft magnetic core 220 so that a second insulating film 240 as shown in FIG. 6E and FIG. 7E is formed.

After that, the portions that correspond to the both ends of the soft magnetic core 220 of the second insulating film 240, are etched so that the through holes 290, 290' as shown in FIG 7F are formed, and the process for forming the second coil 260 is proceeded. Since the thickness of the first and the second insulating films 230, 240 is formed very thin according to the characteristics of the present invention upon etching for formation of the through holes 290, 290', the etching process could be performed in a simple manner. Also, since it is possible to realize the fine-pitched coils due to such simplification of the process, the sensor of high sensitivity is possibly manufactured.

The formation of the second coil 260 is performed in such a way that firstly the seed film (not shown) is formed on the upper surface of the second insulating film 240 in which the through holes 290, 290' are formed, and the photoresist is spread on that seed film; then the second plating mold 280 having a plurality of grooves 280a is formed by exposing and developing processes as shown in FIG 6F and FIG 7F.

After the foregoing second plating mold 280 is formed, metal is filled in the groove 280a of the plating mold 280 by means of the electric plating method so that a coil line 261 is formed as shown in FIG. 6G and FIG 7G At this time, metal is filled in the through holes 290, 290', whereby the first coil 250 at the lower side is connected to the second coil 260 at the upper side by means of a third coil 300 that is filled in the through holes 290, 290'. Therefore, the coils 250, 260 are realized in such a way that these coils enclose the soft magnetic core 220.

If the seed film and the second plating mold 280 is removed after the coil line 261 is formed, the second coil 260 is exposed, whereby a thin type magnetic field detecting element as shown in FIG 6H and FIG 7H is manufactured. Here, the magnetic field detecting element manufactured by the present invention could reduce the whole height of the element as much as the depth of the well 211 formed on the semiconductor substrate 200, thus a thin structure is possibly realized.

In the meantime, on the upper part of the semiconductor substrate 200, a protection film for protecting the structures formed thereon could be formed.

As is apparent from the foregoing, according to the present invention, since the first coil is not projected to the upper part of the semiconductor substrate but positioned in the inside of the well, it is easy to perform planarization of the semiconductor substrate and it is possible to make thin the thickness of the planarization material as well. Therefore, performance improvement of the soft magnetic core is expected thanks to improvement in planarization degree, and simplification of the etching process for forming the through hole is expected thanks to realization of the thin insulating film. Also, the pitch between the coils could be reduced thanks to simplification of the etching process, thus the sensitivity of the sensor could be improved.

Namely, according to the present invention, manufacturing of the magnetic field detecting element is simplified, whereby productivity improvement is expected and the thin-type element of good sensitivity is possibly manufactured as well.

## Claims

1. A method for manufacturing a magnetic field detecting element comprising the steps of:
forming a well (211) of a predetermined depth in a semiconductor substrate (200);
forming a first coil (250) in an inside of the well (211);
forming a soft magnetic core (220) on an upper part of the first coil (250) with a first insulating film (230) intervened; and
forming a second coil (260) on an upper part of the soft magnetic core (220) with a second insulating film (240) intervened,
wherein the first coil comprises (250) a plurality of coil lines (251,252),
and **characterized in that** the well (211) comprises one approximately rectangular well that collapses in the predetermined depth from a surface of the semiconductor substrate(200), the plurality of coil lines (251,252) constituting the first coil (250) are formed in an inside of the one well (211) so that plurality of coil lines (251,252) do not project beyond the surface of the semiconductor substrate(200), and the first insulating film (230) is formed on the upper surface of the semiconductor substrate (200) in which the plurality of coil lines (251,252) are formed in the inside of the one well (211).

2. The method according to claim 1, wherein the well (211) is fanned in such a way that the well has an inclined sidewall that is gradually inclined in its inside from its upper part to its bottom by an etching process.

3. The method according to any preceding claim, wherein the step of forming the first coil (250) further comprises the steps of:
forming a first seed film on a surface of the well;
forming a first plating mold (270) having a plurality of grooves (270a) on the first seed film;
forming a plurality of coil lines (251,252) constituting the first coil (250) by filling up metal in the grooves of the first plating mold (270); and
removing the first plating mold and the first seed film under the first plating mold.

4. The method according to claim 3, wherein metal is filled up in each groove of the first plating mold by means of an electric plating.

5. The method according to any preceding claim, wherein the step of forming the second coil (250) further comprises the steps of:
forming a via hole (290) by etching the first and the second insulating films on both sides of the soft magnetic core;
forming a second seed film on an upper surface of the second insulating film (240) on which the via hole (290) is formed;
forming a second plating mold (280) having a plurality of grooves (280a), on the second seed film;
forming a plurality of coil lines constituting a second coil by filling up metal in each groove of the second plating mold (280), and connecting the first coil with the second coil through the via hole (290); and
removing the second plating mold (280) and the second seed film under the second plating mold.

6. The method according to claim 5, wherein metal is filled up in the grooves of the second plating mold (280) by means of an electric plating.

7. The method according to any preceding claim, further comprising the step of forming a protection film for protecting structures including the second coil.

8. A magnetic field detecting element comprising:
a semiconductor substrate (200);
a soft magnetic core (220) formed on an upper part of the semiconductor substrate;
an insulating film (240,230) positioned on upper and lower parts of the soft magnetic core (220); and
first (250) and second (260) coils formed in such a way that the coils enclose the soft magnetic core (220) with the soft magnetic core and the insulating film (240,230) intervened,
wherein the first coil (250) comprises a plurality of coil lines (251,252),
and **characterized in that** one approximately rectangular well (211) of a predetermined depth is formed in the semiconductor substrate (200), the plurality of coil lines (251,252) constituting the first coil (250) is arranged in an inside of the one well (211), a height of the first coil (250) and a depth of the one well (211) are substantially the same, and the first insulating film (230) is formed on an upper surface of the semiconductor substrate (200) in which the plurality of coil lines (251,252) are formed in the inside of the one well (211).

9. The element according to claim 8, wherein the first coil (250) is positioned at a lower part of the soft magnetic core (220) and the second coil (260) is positioned at an upper part of the soft magnetic core (220), and the coil lines of the first (250) and the second (260) coils are connected by means of a third coil (300) filled in a via hole (290) which passes through the insulating film (240,230) on both sides of the soft magnetic core (220).

10. The element according to claim 8 or 9, wherein the well (211) has an inclined side wall that is gradually inclined in its inside from its upper part to its bottom.

## Patentansprüche

1. Verfahren zum Herstellen eines Elements zum Erkennen eines Magnetfelds das folgende Schritte umfasst:
Bilden einer Vertiefung (211) einer vorherbestimmten Tiefe in einem Halbleitersubstrat (200); Bilden einer ersten Spule (250) in einem Inneren der Vertiefung (211);
Bilden eines weichmagnetischen Kerns (220) auf einem oberen Teil der ersten Spule (250), wobei ein erster Isolierfilm (230) dazwischen liegt; und
Bilden einer zweiten Spule (260) auf einem oberen Teil des weichmagnetischen Kerns (220), wobei ein zweiter Isolierfilm (240) dazwischen liegt,
wobei die erste Spule (250) mehrere Spulenwindungen (251, 252) umfasst,
und **dadurch gekennzeichnet, dass** die Vertiefung (211) eine ungefähr rechteckige Vertiefung umfasst, die in der vorherbestimmten Tiefe von einer Oberfläche des Halbleitersubstrats (200) einsinkt, die mehreren Spulenwindungen (251, 252), die die erste Spule (250) bilden, in einem Inneren der einen Vertiefung (211) gebildet sind, so dass die mehreren Spulenwindungen (251, 252) nicht über die Oberfläche des Halbleitersubstrats (200) hinaus vorstehen und der erste Isolierfilm (230) auf der oberen Oberfläche des Halbleitersubstrats (200) gebildet ist, in dem die mehreren Spulenwindungen (251, 252) in dem Inneren der einen Vertiefung (211) gebildet sind.

2. Verfahren nach Anspruch 1, wobei die Vertiefung (211) derart gefächert ist, dass die Vertiefung eine geneigte Seitenwand aufweist, die durch ein Ätzverfahren stufenweise von ihrem oberen Teil zu ihrem unteren Teil in ihrem Inneren geneigt wird.

3. Verfahren nach einem der vorangehenden Ansprüche, wobei der Schritt des Bildens der ersten Spule (250) weiter folgende Schritte umfasst:
Bilden eines ersten Keimfilms auf einer Oberfläche der Vertiefung;
Bilden einer ersten Plattierungsform (270) mit mehreren Rillen (270a) auf dem ersten Keimfilm;
Bilden mehrerer Spulenwindungen (251, 252), die die erste Spule (250) bilden, durch Einfüllen von Metall in die Rillen der ersten Plattierungsform (270); und
Entfernen der ersten Plattierungsform und des ersten Keimfilms unter der ersten Plattierungsform.

4. Verfahren nach Anspruch 3, wobei Metall mittels einer Elektroplattierung in jede Rille der ersten Plattierungsform eingefüllt wird.

5. Verfahren nach einem der vorangehenden Ansprüche, wobei der Schritt des Bildens der zweiten Spule (250) weiter folgende Schritte umfasst:
Bilden eines Durchgangslochs (290) durch Ätzen des ersten und des zweiten Isolierfilms auf beiden Seiten des weichmagnetischen Kerns;
Bilden eines zweiten Keimfilms auf einer oberen Oberfläche des zweiten Isolierfilms (240) auf dem das Durchgangsloch (290) gebildet ist;
Bilden einer zweiten Plattierungsform (280) mit mehreren Rillen (280a) auf dem zweiten Keimfilm;
Bilden mehrerer Spulenwindungen, die eine zweite Spule bilden, durch Einfüllen von Metall in jede Rille der zweiten Plattierungsform (280) und Verbinden der erste Spule mit der zweiten Spule durch das Durchgangsloch (290); und
Entfernen der zweiten Plattierungsform (280) und des zweiten Keimfilms unter der zweiten Plattierungsform.

6. Verfahren nach Anspruch 5, wobei Metall mittels einer Elektroplattierung in die Rillen der zweiten Plattierungsform (280) eingefüllt wird.

7. Verfahren nach einem der vorangehenden Ansprüche, weiter umfassend den Schritt des Bildens eines Schutzfilms zum Schützen von die zweite Spule umfassenden Strukturen.

8. Element zum Erkennen von Magnetfeldern das Folgendes umfasst:
ein Halbleitersubstrat (200);
einen weichmagnetischen Kern (220), der auf einem oberen Teil des Halbleitersubstrats gebildet ist;
einen Isolierfilm (240, 230), der auf oberen und unteren Teilen des weichmagnetischen Kerns (220) positioniert ist; und
erste (250) und zweite (260) Spulen, die derart gebildet sind, dass die Spulen den weichmagnetischen Kern (220) umschließen, wobei der weichmagnetische Kern und der Isolierfilm (240, 230) dazwischen liegen,
wobei die erste Spule (250) mehrere Spulenwindungen (251, 252) umfasst,
und **dadurch gekennzeichnet, dass** eine ungefähr rechteckige Vertiefung (211) einer vorherbestimmten Tiefe in dem Halbleitersubstrat (200) gebildet ist, die mehreren Spulenwindungen (251, 252), die die erste Spule (250) bilden in einem Inneren der einen Vertiefung (211) angeordnet sind, eine Höhe der ersten Spule (250) und eine Tiefe der einen Vertiefung (211) im Wesentlichen gleich sind, und der erste Isolierfilm (230) auf einer oberen Oberfläche des Halbleitersubstrats (200) gebildet ist, in dem die mehreren Spulenwindungen (251, 252) im Inneren der einen Vertiefung (211) gebildet sind.

9. Element nach Anspruch 8, wobei die erste Spule (250) an einem unteren Teil des weichmagnetischen Kerns (220) positioniert ist und die zweite Spule (260) an einem oberen Teil des weichmagnetischen Kerns (220) positioniert ist, und die Spulenwindungen der ersten (250) und der zweiten Spulen (260) mittels einer dritten Spule (300) verbunden sind, die in ein Durchgangsloch (290) gefüllt ist, das durch den Isolierfilm (240, 230) auf beiden Seiten des weichmagnetischen Kerns (220) verläuft.

10. Element nach Anspruch 8 oder 9, wobei die Vertiefung (211) eine geneigte Seitenwand aufweist, die stufenweise von ihrem oberen Teil zu ihrem unteren Teil in ihrem Inneren geneigt ist.

## Revendications

1. Procédé de fabrication d'un élément de détection de champ magnétique comprenant les étapes suivantes :
la formation d'un puits (211) d'une profondeur prédéterminée dans un substrat à semi-conducteur (200) ;
la formation d'une première bobine (250) dans une partie intérieure du puits (211) ;
la formation d'un noyau magnétique doux (220) sur une partie supérieure de la première bobine (250) avec un premier film isolant (230) intercalé ; et
la formation d'une deuxième bobine (260) sur une partie supérieure du noyau magnétique doux (220) avec un second film isolant (240) intercalé,
dans lequel la première bobine (250) comprend une pluralité de lignes de bobine (251, 252),
et **caractérisé en ce que** le puits (211) comprend un puits approximativement rectangulaire qui s'affaisse dans la profondeur prédéterminée depuis une surface du substrat à semi-conducteur (200), la pluralité de lignes de bobine (251, 252) constituant la première bobine (250) est formée dans une partie intérieure du puits (211) de telle sorte que la pluralité de lignes de bobine (251, 252) ne dépasse pas au-delà de la surface du substrat à semi-conducteur (200), et le premier film isolant (230) est formé sur la surface supérieure du substrat semi-conducteur (200) dans lequel la pluralité de lignes de bobine (251, 252) est formée dans la partie intérieure du puits (211).

2. Procédé selon la revendication 1, dans lequel le puits (211) est conique de façon à avoir une paroi latérale inclinée qui est graduellement inclinée dans sa partie intérieure depuis sa partie supérieure jusqu'à son fond par un processus de gravure.

3. Procédé selon l'une quelconque des revendications précédentes, dans lequel l'étape de formation de la première bobine (250) comprend en outre les étapes suivantes :
la formation d'un premier film d'ensemencement sur une surface du puits ;
la formation d'un premier moule de placage (270) ayant une pluralité de rainures (270a) sur le premier film d'ensemencement ;
la formation d'une pluralité de lignes de bobine (251, 252) constituant la première bobine (250) en remplissant de métal les rainures du premier moule de placage (270) ; et
l'élimination du premier moule de placage et du premier film d'ensemencement sous le premier moule de placage.

4. Procédé selon la revendication 3, dans lequel le métal est rempli dans chaque rainure du premier moule de placage par placage électrique.

5. Procédé selon l'une quelconque des revendications précédentes, dans lequel l'étape de formation de la deuxième bobine (250) comprend en outre les étapes suivantes :
la formation d'un trou débouchant (290) en gravant les premier et second films isolants sur les deux côtés du noyau magnétique doux ;
la formation d'un second film d'ensemencement sur une surface supérieure du second film isolant (240) sur lequel est formé le trou débouchant (290) ;
la formation d'un second moule de placage (280) ayant une pluralité de rainures (280a) sur le second film d'ensemencement ;
la formation d'une pluralité de lignes de bobine constituant une deuxième bobine en remplissant de métal chaque rainure du second moule de placage (280) ; et en connectant la première bobine à la deuxième bobine par le biais du trou débouchant (290) ; et
l'élimination du second moule de placage (280) et du second film d'ensemencement sous le second moule de placage.

6. Procédé selon la revendication 5, dans lequel le métal est rempli dans les rainures du second moule de placage (280) par placage électrique.

7. Procédé selon l'une quelconque des revendications précédentes, comprenant en outre l'étape de formation d'un film de protection pour protéger les structures comportant la deuxième bobine.

8. Elément de détection de champ magnétique comprenant :
un substrat à semi-conducteur (200) ;
un noyau magnétique doux (220) formé sur une partie supérieure du substrat à semi-conducteur ;
un film isolant (240, 230) positionné sur des parties supérieure et inférieure du noyau magnétique doux (220) ; et
des première (250) et deuxième (260) bobines formées de façon à ce que les bobines enferment le noyau magnétique doux (220) avec le noyau magnétique doux et le film isolant (240, 230) intercalés,
dans lequel la première bobine (250) comprend une pluralité de lignes de bobine (251, 252),
et **caractérisé en ce qu'**un puits approximativement rectangulaire (211) d'une profondeur prédéterminée est formé dans le substrat à semi-conducteur (200), la pluralité de lignes de bobine (251, 252) constituant la première bobine (250) est disposée dans une partie intérieure du puits (211), une hauteur de la première bobine (250) et une profondeur du puits (211) sont sensiblement identiques, et le premier film isolant (230) est formé sur une surface supérieure du substrat à semi-conducteur (200) dans lequel la pluralité de lignes de bobine (251, 252) est formée dans la partie intérieure du puits (211).

9. Elément selon la revendication 8, dans lequel la première bobine (250) est positionnée au niveau d'une partie inférieure du noyau magnétique doux (220) et la deuxième bobine (260) est positionnée au niveau d'une partie supérieure du noyau magnétique doux (220), et les lignes de bobine des première (250) et deuxième (260) bobines sont connectées au moyen d'une troisième bobine (300) remplie dans un trou débouchant (290) qui traverse le film isolant (240, 230) sur les deux côtés du noyau magnétique doux (220).

10. Elément selon la revendication 8 ou 9, dans lequel le puits (211) a une paroi latérale inclinée qui est graduellement inclinée dans sa partie intérieure depuis sa partie supérieure jusqu'à son fond.
